# EUROPEAN PATENT SPECIFICATION

(11) **EP 2 728 629 B1**
(45) Date of publication and mention of the grant of the patent: **24.07.2019**
(21) Application number: 13190974.9
(22) Date of filing: 31.10.2013
(51) Int. Cl.: H01L 33/12, H01L 33/00

(54) **Hetero-Substrate for nitride-Based Semiconductor Light Emitting Device, and Method for Manufacturing the same**
Heterosubstrat für lichtemittierende Halbleitervorrichtung auf Nitridbasis und Vorrichtung zur Herstellung davon
Hétéro-substrat pour dispositif électroluminescent à semi-conducteurs à base de nitrure et procédé de fabrication de celui-ci

(30) Priority: 02.11.2012 KR 20120123637
(43) Date of publication of application: 07.05.2014
(73) Proprietor: LG Electronics Inc., Yeongdeungpo-gu SEOUL, 07336 (KR); LG Siltron Incorporated, Gumi-city Gyeongsangbuk-do 730-724 (KR)
(72) Inventor: Jeon, Kiseong, 153-802 Seoul (KR); Lee, Hojun, Gumi-si, Gyeongsangbuk-do (KR); Lee, Kyejin, 730-787 Gumi-si (KR)
(74) Representative: Ter Meer Steinmeister & Partner

(56) References cited:
- EP-A2- 1 211 736
- JP-B1- 5 023 230
- US-A1- 2010 289 067

## Description

### BACKGROUND OF THE INVENTION

### Field of the Invention

The present invention relates to a light emitting device, and more particularly, to a hetero-substrate, a nitride-based semiconductor light emitting device, and a method of manufacturing the same.

### Discussion of the Related Art

Light emitting devices such as light emitting diodes (LED) are p-n junction diodes which convert electric energy into light and can realize a variety of colors by adjusting the composition ratio of compound semiconductors formed of a Group III element compound and a Group V element compound.

In JP 5 023230 B1a nitride semiconductor is disclosed that includes a stacked foundation layer and a functional layer. The stacked foundation layer is formed on an aluminum nitride (AlN) buffer layer formed on a silicon (Si) substrate. The stacked foundation layer includes AlN foundation layers and gallium nitride (GaN) foundation layers being alternately stacked. The functional layer includes a low-concentration part and a high-concentration part provided on the low-concentration part. A substrate-side GaN foundation layer closest to the silicon substrate among the plurality of GaN foundation layers includes first portion and second portion and a third portion provided between the first and second portions. The third portion has a Si concentration not less than 5 x 10¹⁸/cm³ and has a thickness smaller than a sum of those of the first and second portions.

Nitride semiconductors have high thermal stability and wide bandgap energy and thus are receiving considerable attention in the field of optical devices and high-output electronic devices. In particular, blue light emitting devices, green light emitting devices, ultraviolet light emitting devices, and the like, which use nitride semiconductors, are commercially available and widely used.

Such light emitting devices using nitride semiconductors are mainly disposed on a hetero-substrate made of sapphire or silicon carbide (SiC), and technology for forming a light emitting device using a nitride semiconductor on a substrate with conductivity such as a silicon substrate has recently been used.

Such silicon semiconductors have different coefficients of thermal expansion and lattice constants than those of nitride semiconductors and thus are difficult to grow into a thick nitride semiconductor film and to achieve improvement in conductivity by increasing the amount of a dopant.

### SUMMARY OF THE INVENTION

Accordingly, the present invention is directed to a hetero-substrate for a nitride-based semiconductor light emitting device, and a method of manufacturing the same that substantially obviate one or more problems due to limitations and disadvantages of the related art.

An object of the present invention is to provide a hetero-substrate that is fabricated using a silicon semiconductor and thus occurrence of cracks by stress is minimized and the hetero-substrate has an appropriate thickness and conductivity, and a method of manufacturing the same.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

The above identified objectives are solved by the features of the independent claims. Advantegeous embodiments are described in the respective dependent claims. Preferably, a hetero-substrate includes a substrate (10) including a silicon semiconductor, a buffer layer (30) disposed on the substrate, a first semiconductor layer (40) disposed on the buffer layer and including a nitride semiconductor, a second semiconductor layer (53 or 200) disposed on the first semiconductor layer and including a first conductive type nitride semiconductor having a first doping concentration, and a stress control structure (50) disposed between the first semiconductor layer and the second semiconductor layer and including at least one stress compensation layer (51) and at least one third semiconductor layer (52) including a first conductive type nitride semiconductor having a second doping concentration that is the same or lower than the first doping concentration.

The stress control structure (50) may comprise a plurality of stress compensation layers (51) and a plurality of third semiconductor layers (52) that are alternately arranged with respect to each other.

The second doping concentration of the third semiconductor layers (52) increases towards the second semiconductor layer (53).

The stress compensation layer (51) may comprise an AlN layer, and the third semiconductor layer (52) may comprise a GaN layer.

The stress compensation layer (51) may have a thickness of 10 nm to 100 nm.

The second doping concentration may be between 15% and 90% with respect to the first doping concentration.

The first doping concentration may be between 5x10¹⁸/cm³ and 2x10¹⁹/cm3.

The silicon semiconductor may have a (111) crystal plane.

The buffer layer (30) may comprise AlN or AlGaN.

An Al composition of the buffer layer (30) may decrease with increasing distance from the substrate (10).

Preferably, a method of manufacturing a nitride-based semiconductor light emitting device includes forming a nucleation layer (20) on a silicon semiconductor substrate (10), forming a buffer layer (30) on the nucleation layer, forming a first semiconductor layer (40) including a nitride semiconductor on the buffer layer, forming a stress control structure (50) including at least one stress compensation layer (51) and at least one third semiconductor layer (52) including a first conductive type nitride semiconductor having a second doping concentration, on the first semiconductor layer, forming, on the stress control structure, a second semiconductor layer (53 or 200) including a first conductive type nitride semiconductor having a first doping concentration that is greater than the second doping concentration, forming an active layer (300) on the second semiconductor layer, and forming a fourth semiconductor layer (400) including a second conductive type nitride semiconductor on the active layer.

The forming of the stress control structure (50) may comprise alternately forming a plurality of stress compensation layers (51) and a plurality of third semiconductor layers (52) with respect to each other.

The second doping concentration of the third semiconductor layers (52) increases towards the second semiconductor layer (53 or 200).

The stress compensation layer (51) may comprise an AlN layer, and the third semiconductor layer (52) may comprise a GaN layer.

The second doping concentration may be between 15% and 90% with respect to the first doping concentration.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:
FIG. 1 is a sectional view of a hetero-substrate according to an embodiment of the present invention;
FIG. 2 is a sectional view illustrating a structure for explaining stress control effects of the hetero-substrate, confirmed through experiments;
FIGS. 3 through 8 are images showing stress control effects by FIG. 2;
FIG. 9 is a flowchart illustrating processes of manufacturing a hetero-substrate and a light emitting device;
FIG. 10 is a sectional view illustrating a state in which the light emitting device is disposed on the hetero-substrate;
FIG. 11 is a sectional view illustrating attachment of a conductive support layer; and
FIG. 12 is a sectional view of a vertical type light emitting device manufactured using the hetero-substrate, according to an embodiment of the present invention.

### DETAILED DESCRIPTION OF THE INVENTION

Hereinafter, embodiments of the present invention will be described in detail with reference to the accompanying drawings.

However, the present invention allows various modifications and variations and specific embodiments thereof are described with reference to the accompanying drawings and will be described in detail. The present invention should not be construed as limited to the embodiments set forth herein and is defined by the appended claims.

It will be understood that when an element such as a layer, area, or substrate is referred to as being "on" another element, it can be directly on the element, or one or more intervening elements may also be present.

Additionally, it will be understood that although terms such as "first" and "second" may be used herein to describe elements, components, areas, layers and/or regions, the elements, components, areas, layers and/or regions should not be limited by these terms.

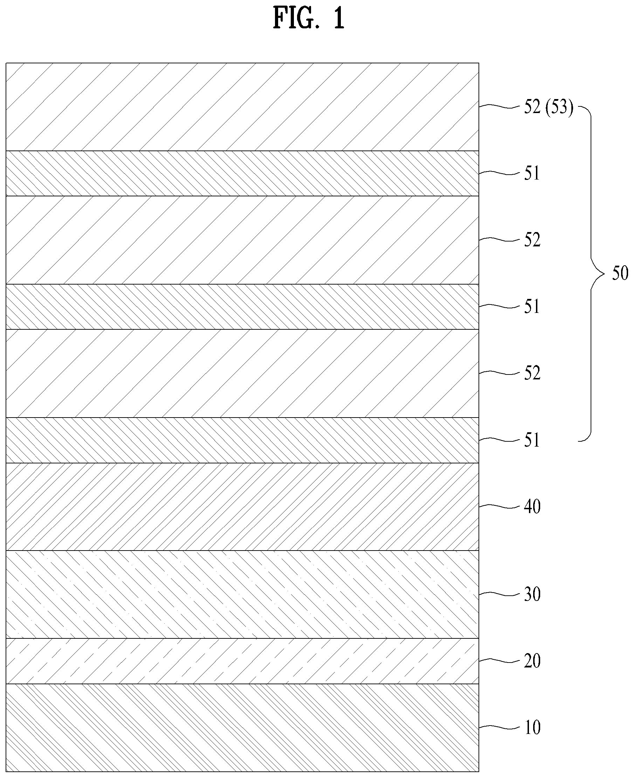

FIG. 1 is a sectional view of a hetero-substrate 100 according to an embodiment of the present invention.

As illustrated in FIG. 1, the hetero-substrate 100 includes a substrate 10 including a silicon (Si) semiconductor, a buffer layer 30 disposed on the substrate 10, and a first semiconductor layer 40 disposed on the buffer layer 30 and including a nitride semiconductor.

The silicon semiconductor substrate 10 is most widely used in general semiconductor manufacturing processes, and can be used to fabricate large-scale wafers, and has high thermal conductivity.

The silicon semiconductor substrate 10 may have a (111)-plane orientation. A surface of the silicon semiconductor substrate 10 having the (111)-plane orientation has a lattice constant of about 3.8403 Å. By contrast, a surface of the silicon semiconductor substrate 10 having a (100)-plane orientation has a lattice constant of about 5.40 Å. Thus, given that gallium nitride (GaN) has a lattice constant of about 3.189 Å, it is beneficial that the silicon semiconductor substrate 10 may have the (111)-plane orientation.

The buffer layer 30 disposed on the silicon semiconductor substrate 10 may be formed of aluminum nitride (AlN) or aluminum gallium nitride (AlGaN).

In this regard, when the buffer layer 30 is formed using AlGaN, the composition of Al included in the buffer layer 30 may decrease with increasing distance from the silicon semiconductor substrate 10, and the Al composition may linearly decrease or decrease stepwise. The Al composition may be between 0.1 and 0.9 with respect to Ga according to the thickness of the buffer layer 30, preferably between 0.2 and 0.6. In addition, the buffer layer 30 may also have a uniform composition throughout the entire thickness thereof.

The buffer layer 30 may reduce crystal defects (mainly, dislocation defects) occurring due to lattice constant mismatch and differences in coefficient of thermal expansion between a gallium nitride (GaN) thin film and the silicon semiconductor substrate 10 in a process of forming a semiconductor thin film formed of a nitride such as GaN on the silicon semiconductor substrate 10, and may prevent occurrence of cracks in the GaN thin film by eliminating stress applied to the GaN thin film.

The buffer layer 30 may have a thickness between 100 nm and 1.5 µm.

A nucleation layer 20 may be disposed between the silicon semiconductor substrate 10 and the buffer layer 30. The nucleation layer 20 may be formed using AlN, may determine initial crystal growth conditions for forming the buffer layer 30, and may prevent Ga atoms included in a GaN layer formed thereabove from permeating into the substrate 10 due to a melt-back phenomenon.

The first semiconductor layer 40 including a nitride semiconductor is disposed on the above-described buffer layer 30. The first semiconductor layer 40 may be formed of GaN, in particular, undoped GaN.

In some cases, the first semiconductor layer 40 may be doped and may have a lower doping concentration than that of a nitride semiconductor layer (a third semiconductor layer 52) included in a stress control structure 50, which will be described below. In this regard, silicon (Si) may be used as a dopant, and the doping concentration may be 3x10¹⁸/cm³ or less.

At an upper portion of the hetero-substrate 100 having the above-described structure may be disposed a second semiconductor layer 53 including a first conductive type nitride semiconductor. The second semiconductor layer 53 may have a first doping concentration.

The stress control structure 50 including at least one stress compensation layer 51 and at least one third semiconductor layer 52 including a first conductive type nitride semiconductor may be disposed between the first semiconductor layer 40 and the second semiconductor layer 53.

In this regard, the first conductive type may be an n-type or p-type, as desired. Hereinafter, an n-type will be described as the first conductive type by way of example.

In addition, the second semiconductor layer 53 may include the stress control structure 50 as desired and may be a separate highly doped n-type semiconductor layer. In addition, the second semiconductor layer 53 may be an n-type semiconductor layer constituting a portion of a light emitting device.

The second semiconductor layer 53 may have a thickness between 0.5 µm and 5 µm.

In this regard, the stress compensation layer 51 of the stress control structure 50 may include AlN, and the third semiconductor layer 52 may include GaN. In some cases, the stress compensation layer 51 may include AlGaN.

The stress compensation layer 51 and the third semiconductor layer 52 may include a plurality of stress compensation layers 51 and a plurality of third semiconductor layers 52 that are alternately formed with respect to each other. In this regard, the stress compensation layers 51 and the third semiconductor layers 52 may be alternately formed up to six times, without being limited thereto.

The stress compensation layer 51 may have a thickness between 10 and 100 nm, and the third semiconductor layer 52 may have a thickness between 30 nm and 1.5 µm.

The third semiconductor layer 52 has a second doping concentration that is lower than the first doping concentration of the second semiconductor layer 53.

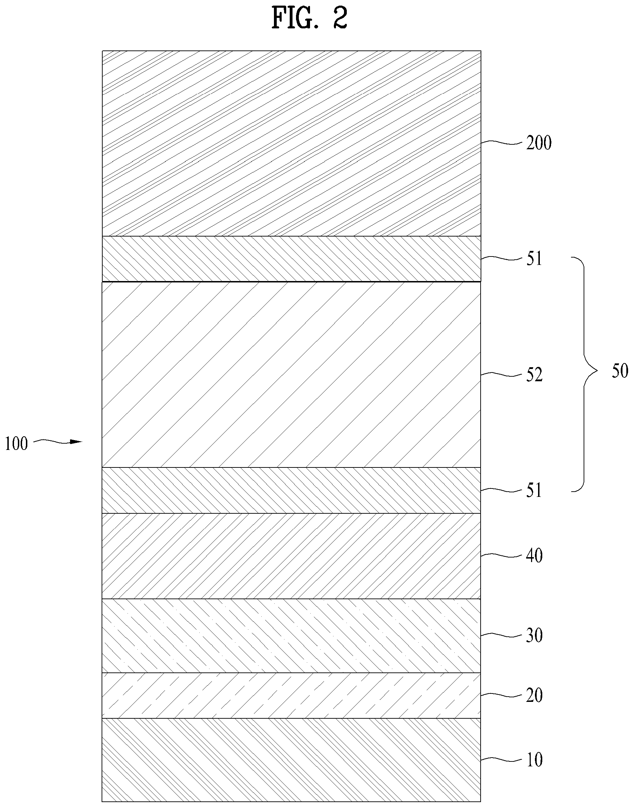

That is, when the second semiconductor layer 53 is a different highly doped semiconductor layer than the stress control structure 50, the doping concentration of the second semiconductor layer 53 may be similar to that of an n-type semiconductor layer 200 (see FIG. 2). The doping concentration may be between 5x10¹⁸/cm³ and 2x10¹⁹/cm³.

In this regard, a doping concentration, i.e., the second doping concentration, of the third semiconductor layer 52 may be between 15% and 90% with respect to the first doping concentration.

The doping concentration of the third semiconductor layers 52 increases with increasing distance from the substrate 10. That is, the doping concentration of the third semiconductor layers 52 increases towards the second semiconductor layer 53.

When a light emitting device is manufactured using the hetero-substrate 100, an n-type nitride semiconductor layer having a sufficient thickness of 3 µm or greater and having an n-type dopant concentration of 5x10¹⁸/cm³ or greater is generally needed.

The n-type nitride semiconductor layer having the above-described thickness and doping concentration may be grown on a sapphire or SiC substrate. However, it is not easy to grow the n-type nitride semiconductor layer on a Si semiconductor substrate.

Cracking occurring in the growth process is the greatest obstacle. That is, when GaN is grown into a thick film, cracks may occur due to differences in coefficient of thermal expansion and lattice constant between a silicon semiconductor and GaN.

In order for the light emitting device manufactured on the hetero-substrate 100 to perform satisfactorily, a Si doping concentration of the nitride semiconductor included in the hetero-substrate 100 needs to be high, i.e., between 4x10¹⁸/cm³ and 3x10¹⁹/cm³, and it is beneficial that the thickness of the nitride semiconductor has a thickness of 1 µm or greater.

Due to differences in lattice constant and coefficient of thermal expansion of Si and GaN, it is not easy to achieve a large thickness. In addition, as doping concentration increases, dopant-induced tensile stress increases and thus cracking may occur due to tensile stress and, accordingly, increase in doping concentration is limited.

However, in the hetero-substrate 100 having the above-described structure, a thick n-type nitride semiconductor layer may be formed on the silicon semiconductor substrate 10 using a high-concentration dopant without occurrence of cracking.

By using the hetero-substrate 100, one of the biggest obstacles to a light emitting device using a Si substrate, i.e., cracking, may be addressed, which is expected to bring substantial advances in development of light emitting devices and electronic devices that are based on a silicon substrate.

FIG. 2 is a view illustrating a state in which the n-type semiconductor layer 200 is grown on the hetero-substrate 100, and experimental examples were performed such that a GaN layer having a dopant (Si) concentration of 7x10¹⁸/cm³ and a thickness of 2 µm was grown on the hetero-substrate 100 by varying the doping concentration of the third semiconductor layer 52 of the stress control structure 50, as shown in Table 1. In this regard, the third semiconductor layer 52 includes a Si dopant or undoped GaN.

That is, when the n-type semiconductor layer 200 is disposed on the hetero-substrate 100 including the silicon semiconductor substrate 10, the nucleation layer 20, the buffer layer 30, the first semiconductor layer 40, and the stress control structure 50, cracking rate according to changes in doping concentration of the third semiconductor layer 52 included in the stress control structure 50 is shown.

In the experimental examples, the nucleation layer 20 used AlN, and the buffer layer 30 used AlGaN. The stress compensation layer 51 of the stress control structure 50 used AlN, and the first semiconductor layer 40 used undoped GaN.

**<Table 1>**

| Sample | Dopant (Si) concentration |
|---|---|
| 1 | Un-doped |
| 2 | 6.0x10¹⁷/cm³ |
| 3 | 1.2x10¹⁸/cm³ |
| 4 | 2.5x10¹⁸/cm³ |
| 5 | 3.7x10¹⁸/cm³ |
| 6 | 5.0x10¹⁸/cm³ |

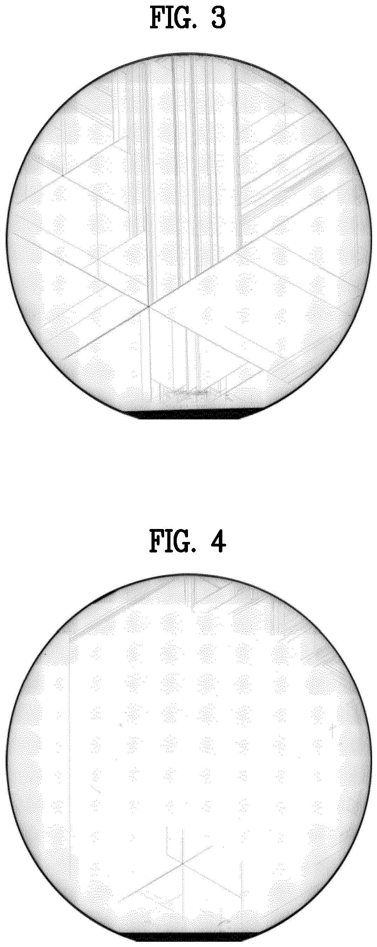

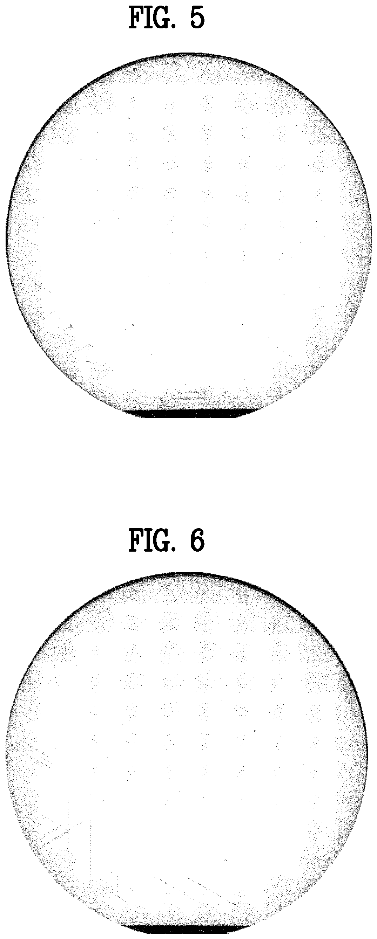

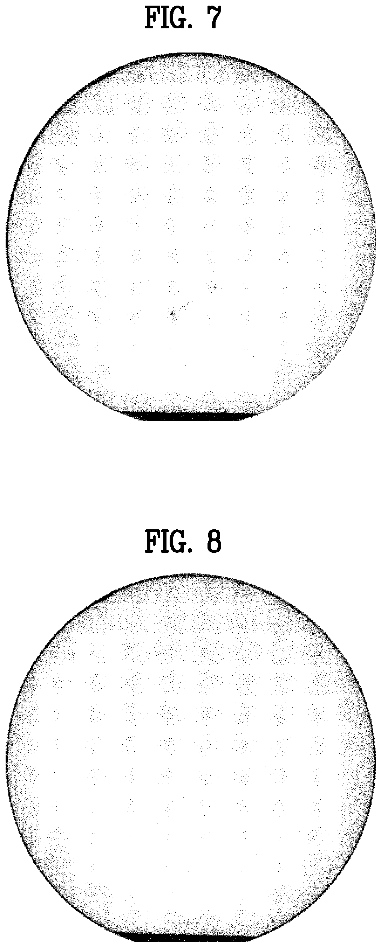

Experimental results are as illustrated in FIGS. 3 to 8. FIGS. 3 to 8 respectively correspond to Samples 1 to 6, and FIGS. 3 to 8 are images showing occurrence of cracks.

As seen from the results illustrated in FIGS. 3 to 8, the lowest crack density was exhibited when the dopant concentration of the third semiconductor layer 52 was between the dopant concentration of the n-type semiconductor layer 200 and the dopant concentration of the first semiconductor layer 40. In addition, when the doping concentration exceeds the doping concentration of Sample 4, i.e., 2.5x10¹⁸/cm³, dopant concentration has little influence upon cracking rate.

Thus, it can be confirmed that the dopant concentration of the third semiconductor layer 52 is between 15% and 90% with respect to the doping concentration of an n-type semiconductor layer (in some cases, the n-type semiconductor layer 200 constituting a portion of a light emitting device or the outermost layer 52 or 53 of the stress control structure 50) disposed on the hetero-substrate 100.

As such, due to the stress control structure 50 including the third semiconductor layer 52 having a doping concentration varying with respect to an n-type semiconductor layer disposed uppermost, occurrence of cracks in the GaN thin film may be prevented.

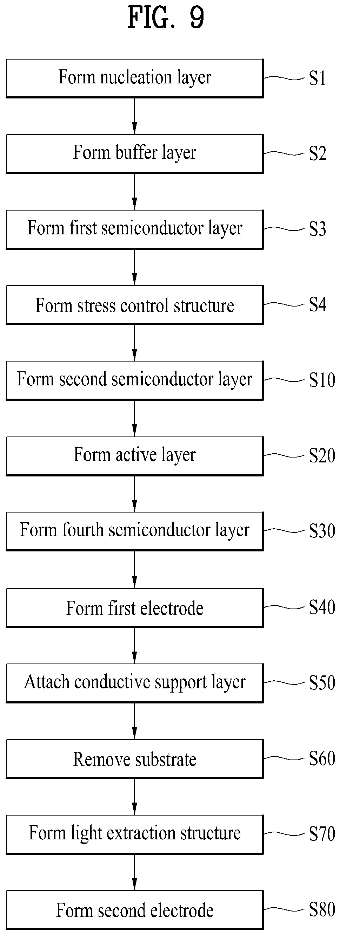

Hereinafter, a process of manufacturing the hetero-substrate 100 and a process of manufacturing a vertical type light emitting device using the hetero-substrate 100 will be described in detail with reference to FIG. 9.

First, chemical pretreatment is performed on the silicon semiconductor substrate 10 having a (111)-plane orientation. That is, washing is primarily performed to remove organic contaminants, fine particles, and the like present on an upper surface of the silicon semiconductor substrate 10.

Subsequently, a natural oxide film formed on the silicon semiconductor substrate 10 is secondarily removed using dilute HF.

Once chemical pretreatment of the silicon semiconductor substrate 10 is completed, the silicon semiconductor substrate 10 is placed in a metal organic chemical vapor deposition (MOCVD) apparatus, and then a thermal cleaning process is performed thereupon using hydrogen at a temperature between 1000 and 1200°C.

However, in addition to MOCVD, other methods known in the art, such as molecular beam epitaxy (MBE), hydride vapor phase epitaxy (HVPE), and the like may be used.

Next, the nucleation layer 20 is formed on the silicon semiconductor substrate 10 (operation S1). First, an Al coating process using a trimethylaluminum (TMAl) source is performed at the temperature of the thermal cleaning process to form an Al coating layer on an upper surface of the silicon semiconductor substrate 10.

The Al coating layer is formed to prevent reaction between Si atoms on the upper surface of the silicon semiconductor substrate 10 and N atoms of NH₃ as a source gas in a subsequent process of forming an AlN layer in formation of the nucleation layer 20.

After formation of the Al coating layer is completed, reaction between the Al coating layer and NH₃ occurs by passing NH₃ over the upper surface of the silicon semiconductor substrate 10 at a temperature between 1000 and 1200°C under a hydrogen atmosphere to form an AlN layer, thereby completing formation of the nucleation layer 20.

The nucleation layer 20 may be formed under the same temperature conditions as those used when forming the Al coating layer.

In addition, the nucleation layer 20 prevents Ga atoms included in a nitride semiconductor formed in a subsequent process from permeating into the silicon substrate 10 due to a melt-back phenomenon.

Next, the buffer layer 30 is formed using AlGaN (operation S2). In this regard, as described above, the Al composition ratio may vary.

The buffer layer 30 may alleviate stress occurring due to differences in coefficient of thermal expansion between a nitride semiconductor thin film formed in a subsequent process and the silicon semiconductor substrate 10.

The first semiconductor layer 40 is formed on the buffer layer 30 using raw materials, i.e., trimethylgallium (TMGa) and NH₃. The first semiconductor layer 40 is formed of GaN.

In addition, the first semiconductor layer 40 is formed close to the silicon semiconductor substrate 10 formed therebelow and thus, if the thickness thereof is not appropriately adjusted, there is risk of permeation of Ga atoms included in the first semiconductor layer 40 into the silicon semiconductor substrate 10 due to the melt-back phenomenon.

Thus, the first semiconductor layer 40 may have an appropriate thickness so as not to cause permeation of the Ga atoms into the silicon semiconductor substrate 10.

After formation of the first semiconductor layer 40, the stress control structure 50 including the stress compensation layer 51 and the third semiconductor layer 52 is formed (operation S4).

For this operation, first, an AlN layer is formed as the stress compensation layer 51 by passing TMAl and NH₃ over the upper surface of the first semiconductor layer 40 at a temperature between 700 °C and 1100°C under a hydrogen atmosphere.

The stress compensation layer 51 may alleviate stress occurring due to lattice constant mismatch and differences in coefficient of thermal expansion between the silicon substrate 10 and a GaN thin film in a subsequent process of forming the GaN thin film as the third semiconductor layer 52. Considering such function, the stress compensation layer 51 may have an appropriate thickness.

Next, the third semiconductor layer 52 is formed on the stress compensation layer 51 using Si-doped GaN and then growth of the stress compensation layer 51 and the third semiconductor layer 52 is repeated to achieve a desired thickness of the finally obtained GaN layer and a desired Si doping concentration.

For growth of n-type GaN, the second semiconductor layer 53 having a desired Si doping concentration is formed (operation S10).

In this regard, as described above, the doping concentration of the third semiconductor layer 52 is set lower than the second semiconductor layer 53. A detailed description of such doping concentration has been described hereinabove.

Hereinafter, a process of manufacturing a vertical type light emitting device using the hetero-substrate 100 will be described.

The second semiconductor layer 53 may act as the n-type semiconductor layer 200 of the light emitting device and, as desired, the n-type semiconductor layer 200 may further be formed on the second semiconductor layer 53.

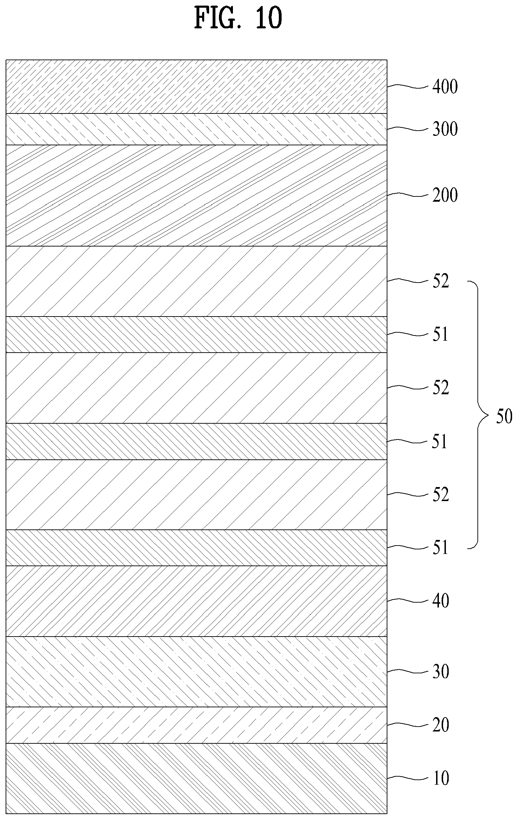

As illustrated in FIG. 10, an active layer 300 is formed on the second semiconductor layers 53 and 200 (operation S20). The active layer 300 may have a multiple quantum well structure and may be formed of a semiconductor based on a nitride such as indium gallium nitride (InGaN), GaN, aluminum indium gallium nitride (AlInGaN), or the like.

Subsequently, a fourth semiconductor layer 400 is formed on the active layer 300 (operation S30). The fourth semiconductor layer 400 is formed using a nitride semiconductor such as a p-type GaN semiconductor. Hereinafter, a p-type semiconductor layer will be described as the fourth semiconductor layer 400.

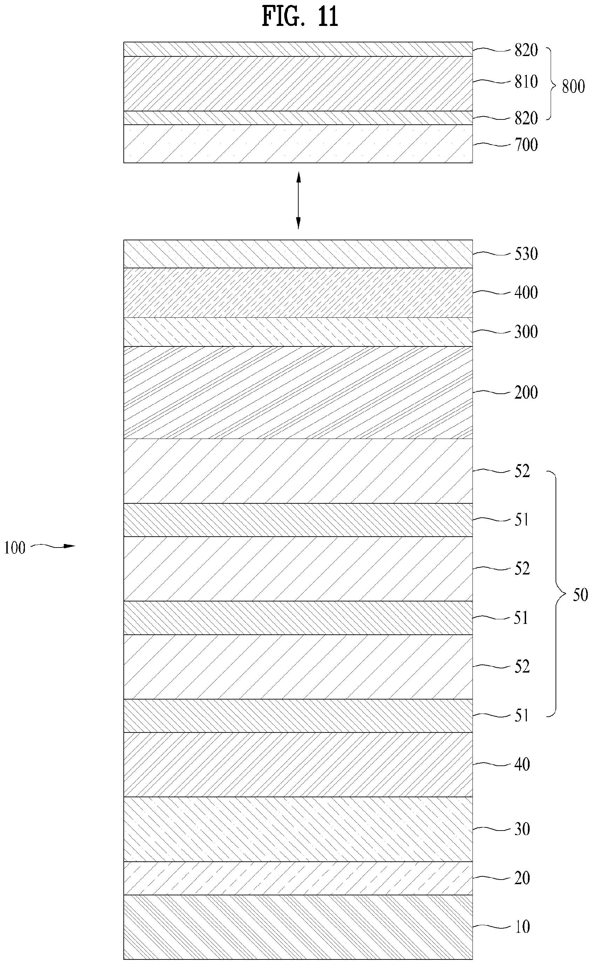

Next, as illustrated in FIG. 11, a first electrode 530 is formed on the p-type semiconductor layer 400 (operation S40). The first electrode 530 may be a p-type electrode and may also act as a reflective layer.

Next, a conductive support layer 800 is adhered using an adhesive metal layer 700 (operation S50). The conductive support layer 800 supports a stacked structure in a subsequent process of removing the substrate 10 and forms a supporting structure of the light emitting device.

The conductive support layer 800 may have a structure in which an ohmic electrode 820 is formed on opposite surfaces of the semiconductor substrate 10. In some cases, a metal support layer (not shown) may be used as the conductive support layer 800.

Next, the silicon semiconductor substrate 10 is removed (operation S60). Removal of the silicon semiconductor substrate 10 may be performed using a chemical method such as etching.

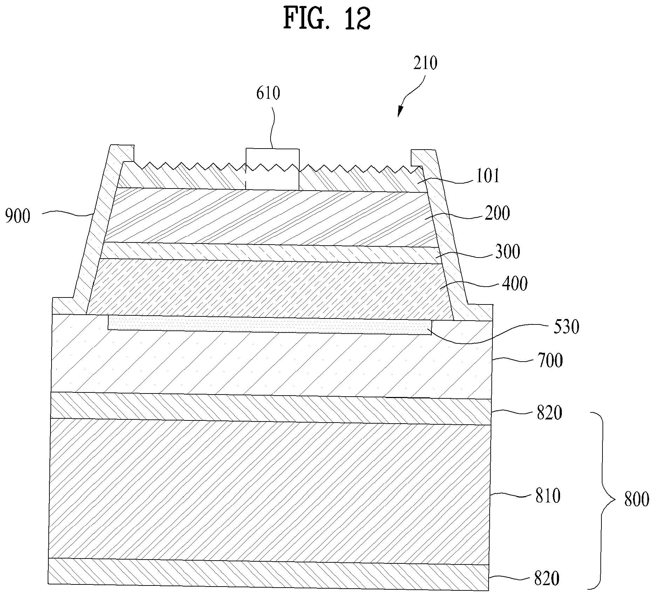

Subsequently, a light extraction structure 210 as illustrated in FIG. 12 is formed (operation S70). In this regard, at least a portion of the hetero-substrate 100 from which the silicon semiconductor substrate 10 has been removed may be used to form the light extraction structure 210.

For example, after removal of the silicon semiconductor substrate 10, portions of the nucleation layer 20 and the buffer layer 30 may be removed and the remaining portion may be used to form the light extraction structure 210.

Since the thickness of the n-type semiconductor layer 200 formed on the hetero-substrate 100 including the silicon semiconductor substrate 10 is relatively small, at least a portion of the hetero-substrate 101 may be used to form the light extraction structure 210.

In some cases, the light extraction structure 210 may also be formed after removal of the buffer layer 30 or the first semiconductor layer 40.

The light extraction structure 210 may be formed using a method such as etching.

Subsequently, after a process such as trench etching for formation of a region for separating individual light emitting devices is performed, a process of forming passivation layers 900 on side surfaces of the exposed semiconductor structure of the light emitting device may further be performed.

Next, a second electrode 610 electrically connected to the n-type semiconductor layer 200 (or the third semiconductor layer 53) is formed (operation S80).

In this regard, when the portion of the hetero-substrate 100 at which the light extraction structure 210 is formed has a lower conductivity than the n-type semiconductor layer 200, etching may be performed so as to expose a portion of the n-type semiconductor layer 200 and then the second electrode 610 may be formed on the exposed portion thereof.

A structure of the vertical type light emitting device manufactured through the above-described processes is as illustrated in FIG. 12. In addition, a horizontal type light emitting device may also be manufactured using the hetero-substrate 100.

It will be apparent to those skilled in the art that various modifications and variations can be made in the present invention without departing from the scope of the inventions. Thus, it is intended that the present invention is defined by the appended claims.

## Claims

1. A hetero-substrate for a nitride-based semiconductor light emitting device comprising:
a substrate (10) comprising a silicon semiconductor;
a buffer layer (30) disposed on the substrate;
a first semiconductor layer (40) disposed on the buffer layer (30) and comprising a nitride semiconductor;
a second semiconductor layer (53, 200) disposed on the first semiconductor layer (40) and comprising a first conductive type nitride semiconductor having a first doping concentration; and
a stress control structure (50) disposed between the first semiconductor layer (40) and the second semiconductor layer (53, 200) and comprising at least one stress compensation layer (51) and at least one third semiconductor layer (52) comprising the first conductive type nitride semiconductor having a second doping concentration that is the same or lower than the first doping concentration, wherein the stress control structure (50) comprises a plurality of stress compensation layers (51) and a plurality of third semiconductor layers (52) that are alternately arranged with respect to each other, **characterised in that** the second doping concentration of the third semiconductor layers (52) increases towards the second semiconductor layer (53).

2. The hetero-substrate according to claim 1, wherein the stress compensation layer (51) comprises an aluminum nitride, A1N, layer, and the third semiconductor layer (52) comprises a gallium nitride, GaN, layer.

3. The hetero-substrate according to anyone of claims 1 or 2, wherein the stress compensation layer (51) has a thickness of 10 nm to 100 nm.

4. The hetero-substrate according to anyone of the preceding claims, wherein the second doping concentration is between 15% and 90% with respect to the first doping concentration.

5. The hetero-substrate according to anyone of the preceding claims, wherein the first doping concentration is between 5x10¹⁸/cm³ and 2x10¹⁹/cm³.

6. The hetero-substrate according to anyone of the preceding claims, wherein the silicon semiconductor has a (111) crystal plane, and/or
wherein the buffer layer (30) comprises AlN or aluminum gallium nitride, AlGaN.

7. The hetero-substrate according to claim 6, wherein the buffer layer (30) comprises AlGaN, and wherein an aluminum, Al, composition of the buffer layer (30) decreases with increasing distance from the substrate (10).

8. A method of manufacturing a hetero-substrate for a nitride-based semiconductor light emitting device, the method comprising:
forming a buffer layer (30) on a silicon semiconductor substrate (10);
forming a first semiconductor layer (40) comprising a nitride semiconductor on the buffer layer;
forming a stress control structure (50) comprising at least one stress compensation layer (51) and at least one third semiconductor layer (52) comprising a first conductive type nitride semiconductor having a second doping concentration, on the first semiconductor layer; and
forming, on the stress control structure (50), a second semiconductor layer (53, 200) comprising the first conductive type nitride semiconductor having a first doping concentration that is greater than the second doping concentration, wherein the forming of the stress control structure (50) comprises alternately forming a plurality of stress compensation layers (51) and a plurality of third semiconductor layers (52) with respect to each other, **characterised in that** the second doping concentration of the third semiconductor layers (52) increases towards the second semiconductor layer (53, 200).

9. The method according to claim 8, further comprising at least one of:
forming a nucleation layer (20) on the silicon semiconductor substrate (10), wherein the buffer layer (30) is formed on the nucleation layer (20);
forming an active layer (300) on the second semiconductor layer (200) and
forming a fourth semiconductor layer (400) comprising a second conductive type nitride semiconductor on the active layer.

10. The method according to claim 8, wherein the stress compensation layer (51) comprises an aluminum nitride, AlN, layer, and the third semiconductor layer (52) comprises a gallium nitride, GaN, layer.

11. The method according to anyone of claims 8 to 10, wherein the second doping concentration is between 15% and 90% with respect to the first doping concentration.

## Patentansprüche

1. Heterosubstrat für eine lichtemittierende Halbleitervorrichtung auf Nitridbasis, umfassend:
ein Substrat (10) umfassend einen Siliciumhalbleiter;
eine Pufferschicht (30), die auf dem Substrat angeordnet ist;
eine erste Halbleiterschicht (40), die auf der Pufferschicht (30) angeordnet ist und einen Nitridhalbleiter umfasst;
eine zweite Halbleiterschicht (53, 200), die auf der ersten Halbleiterschicht (40) angeordnet ist und einen ersten Nitridhalbleiter vom leitfähigen Typ umfasst, der eine erste Dotierkonzentration aufweist; und
eine Spannungsregulierstruktur (50), die zwischen der ersten Halbleiterschicht (40) und der zweiten Halbleiterschicht (53, 200) angeordnet ist und mindestens eine Spannungskompensationsschicht (51) und mindestens eine dritte Halbleiterschicht (52) umfasst, die den ersten Nitridhalbleiter vom leitfähigen Typ umfasst, der eine zweite Dotierkonzentration aufweist, die dieselbe wie oder geringer als die erste Dotierkonzentration ist,
wobei
die Spannungsregulierstruktur (50) eine Mehrzahl von Spannungskompensationsschichten (51) und eine Mehrzahl dritter Halbleiterschichten (52) umfasst, die abwechselnd mit Bezug aufeinander angeordnet sind, **dadurch gekennzeichnet, dass**
die zweite Dotierkonzentration der dritten Halbleiterschichten (52) auf die zweite Halbleiterschicht (53) zu steigt.

2. Heterosubstrat nach Anspruch 1, wobei die Spannungskompensationsschicht (51) eine Aluminiumnitrid-, AIN-, Schicht umfasst und die dritte Halbleiterschicht (52) eine Galliumnitrid-, GaN-, Schicht umfasst.

3. Heterosubstrat nach irgendeinem der Ansprüche 1 oder 2, wobei die Spannungskompensationsschicht (51) eine Dicke von 10 nm bis 100 nm aufweist.

4. Heterosubstrat nach irgendeinem der vorhergehenden Ansprüche, wobei die zweite Dotierkonzentration zwischen 15 % und 90 % mit Bezug auf die erste Dotierkonzentration liegt.

5. Heterosubstrat nach irgendeinem der vorhergehenden Ansprüche, wobei die erste Dotierkonzentration zwischen 5x10¹⁸/cm³ und 2x10¹⁹/cm³ liegt.

6. Heterosubstrat nach irgendeinem der vorhergehenden Ansprüche, wobei der Siliciumhalbleiter eine (111) Kristallebene aufweist und/oder
wobei die Pufferschicht (30) AlN oder Aluminiumgalliumnitrid AlGaN umfasst.

7. Heterosubstrat nach Anspruch 6,
wobei die Pufferschicht (30) AlGaN umfasst und wobei eine Aluminium-, Al-, Zusammensetzung der Pufferschicht (30) mit zunehmendem Abstand von dem Substrat (10) abnimmt.

8. Verfahren für die Herstellung eines Heterosubstrats für eine lichtemittierende Halbleitervorrichtung auf Nitridbasis, wobei das Verfahren Folgendes umfasst:
Bilden einer Pufferschicht (30) auf einem Siliciumhalbleitersubstrat (10);
Bilden einer ersten Halbleiterschicht (40) umfassend einen Nitridhalbleiter auf der Pufferschicht;
Bilden einer Spannungsregulierstruktur (50) umfassend mindestens eine Spannungskompensationsschicht (51) und mindestens eine dritte Halbleiterschicht (52), die einen ersten Nitridhalbleiter vom leitfähigen Typ, der eine zweite Dotierkonzentration aufweist, auf der ersten Halbleiterschicht umfasst; und
Bilden, auf der Spannungsregulierstruktur (50), einer zweiten Halbleiterschicht (53, 200), die den ersten Nitridhalbleiter vom leitfähigen Typ umfasst, der eine erste Dotierkonzentration aufweist, die höher ist als die zweite Dotierkonzentration,
wobei
das Bilden der Spannungsregulierstruktur (50) das abwechselnde Bilden einer Mehrzahl von Spannungskompensationsschichten (51) und einer Mehrzahl dritter Halbleiterschichten (52) mit Bezug aufeinander umfasst, **dadurch gekennzeichnet, dass** die zweite Dotierkonzentration der dritten Halbleiterschichten (52) auf die zweiten Halbleiterschichten (53, 200) zu zunimmt.

9. Verfahren nach Anspruch 8, ferner mindestens eines umfassend von:
Bilden einer Keimbildungsschicht (20) auf dem Siliciumhalbleitersubstrat (10), wobei die Pufferschicht (30) auf der Keimbildungsschicht (20) gebildet wird;
Bilden einer aktiven Schicht (300) auf der zweiten Halbleiterschicht (200) und
Bilden einer vierten Halbleiterschicht (400), die einen zweiten Nitridhalbleiter vom leitfähigen Typ auf der aktiven Schicht umfasst.

10. Verfahren nach Anspruch 8, wobei die Spannungskompensationsschicht (51) eine Aluminiumnitrid-, AIN-, Schicht umfasst und die dritte Halbleiterschicht (52) eine Galliumnitrid-, GaN-, Schicht umfasst.

11. Verfahren nach irgendeinem der Ansprüche 8 bis 10, wobei die zweite Dotierkonzentration zwischen 15 % und 90 % mit Bezug auf die erste Dotierkonzentration liegt.

## Revendications

1. Un hétéro-substrat pour un dispositif émettant de la lumière semi-conducteur à base de nitrure, comprenant:
un substrat (10) comprenant un semi-conducteur en silicium;
une couche tampon (30) disposée sur le substrat;
une première couche semi-conductrice (40) disposée sur la couche tampon (30) et comprenant un semi-conducteur nitrure;
une seconde couche semi-conductrice (53, 200) disposée sur la première couche semi-conductrice (40) et comprenant un semi-conducteur nitrure de premier type conducteur ayant une première concentration de dopage; et
une structure de contrôle de contrainte (50) disposée entre la première couche semi-conductrice (40) et la seconde couche semi-conductrice (53, 200) et comprenant au moins une couche de compensation de contrainte (51) et au moins une troisième couche semi-conductrice (52) comprenant le semi-conducteur nitrure du premier type conducteur ayant une seconde concentration de dopage égale ou inférieure à la première concentration de dopage,
dans lequel
la structure de contrôle de contrainte (50) comprend une pluralité de couches de compensation de contrainte (51) et une pluralité de troisièmes couches semi-conductrices (52) qui sont agencées alternativement les unes par rapport aux autres, **caractérisé en ce que**
la seconde concentration de dopage des troisièmes couches semi-conductrices (52) augmente en direction de la seconde couche semi-conductrice (53).

2. L'hétéro-substrat selon la revendication 2, dans lequel la couche de compensation de contrainte (51) comprend une couche de nitrure d'aluminium, AlN, et la troisième couche semi-conductrice (52) comprend une couche de nitrure de gallium, GaN.

3. L'hétéro-substrat selon l'une quelconque des revendications 1 ou 2, dans lequel la couche de compensation de contrainte (51) a une épaisseur de 10 nm à 100 nm.

4. L'hétéro-substrat selon l'une quelconque des revendications précédentes, dans lequel la seconde concentration de dopage est comprise entre 15% et 90% par rapport à la première concentration de dopage.

5. L'hétéro-substrat selon l'une quelconque des revendications précédentes, dans lequel la première concentration de dopage est comprise entre 5x10¹⁸/cm³ et 2x10¹⁹/cm³.

6. L'hétéro-substrat selon l'une quelconque des revendications précédentes, dans lequel le semi-conducteur en silicium a un plan cristallin (111), et/ou
dans lequel la couche tampon (30) comprend de l'AlN ou du nitrure d'aluminium-gallium, AlGaN.

7. L'hétéro-substrat selon la revendication 6,
dans lequel la couche tampon (30) comprend de l'AlGaN, et
dans lequel une composition aluminium, Al, de la couche tampon (30) diminue avec l'augmentation de la distance par rapport au substrat (10).

8. Un procédé de fabrication d'un hétéro-substrat pour un dispositif émettant de la lumière semi-conducteur à base de nitrure, le procédé comprenant:
la formation d'une couche tampon (30) sur un substrat semi-conducteur en silicium (10);
la formation d'une première couche semi-conductrice (40) comprenant un semi-conducteur nitrure sur la couche tampon;
la formation d'une structure de contrôle de contrainte (50) comprenant au moins une couche de compensation de contrainte (51) et au moins une troisième
couche semi-conductrice (52) comprenant un semi-conducteur nitrure de premier type conducteur ayant une seconde
concentration de dopage, sur la première couche semi-conductrice; et
la formation, sur la structure de contrôle de contrainte (50), d'une seconde couche semi-conductrice (53, 200) comprenant le semi-conducteur nitrure du premier type conducteur ayant une première concentration de dopage qui est supérieure à la seconde concentration de dopage,
dans lequel
la formation de la structure de contrôle de contrainte (50) comprend la formation alternée d'une pluralité de couches de compensation de contrainte (51) et d'une pluralité de troisièmes couches semi-conductrices (52) les unes par rapport aux autres, **caractérisé en ce que** la seconde concentration de dopage des troisièmes couches semi-conductrices (52) augmente en direction de la seconde couche semi-conductrice (53, 200).

9. Le procédé selon la revendication 8, comprenant en outre au moins l'un parmi:
la formation d'une couche de nucléation (20) sur le substrat semiconducteur en silicium (10), dans lequel la couche tampon (30) est formée sur la couche de nucléation (20);
la formation d'une couche active (300) sur la seconde couche semi-conductrice (200); et
la formation d'une quatrième couche semi-conductrice (400) comprenant un semi-conducteur nitrure de second type conducteur sur la couche active.

10. Le procédé selon la revendication 8, dans lequel la couche de compensation de contrainte (51) comprend une couche de nitrure d'aluminium, AlN, et la troisième couche semi-conductrice (52) comprend une couche de nitrure de gallium, GaN.

11. Le procédé selon l'une quelconque des revendications 8 à 10, dans lequel la seconde concentration de dopage est comprise entre 15% et 90% par rapport à la première concentration de dopage.
